# EUROPÄISCHE PATENTSCHRIFT

(11) **EP 1 112 607 B1**
(45) Veröffentlichungstag und Bekanntmachung des Hinweises auf die Patenterteilung: **12.06.2002**
(21) Anmeldenummer: 99953696.4
(22) Anmeldetag: 02.09.1999
(51) Int. Cl.: H01R 12/34

(54) **PLATINEN-STECKKONTAKT-ANORDNUNG**
BOARD-PLUG-IN-CONTACT ARRANGEMENT
ENSEMBLE PLATINE-CONTACT ENFICHABLE

(30) Priorität: 10.09.1998 DE 19841467
(43) Veröffentlichungstag der Anmeldung: 04.07.2001
(73) Patentinhaber: SIEMENS AKTIENGESELLSCHAFT, 80333 München (DE)
(72) Erfinder: BELAU, Horst, D-84085 Langquaid (DE); HELD, Joachim, D-81739 München (DE)
(86) Internationale Anmeldenummer: DE9902783
(87) Internationale Veröffentlichungsnummer: WO0016447

(56) Entgegenhaltungen:
- DE-A- 19 609 425
- DE-A- 19 706 281
- US-A- 3 693 052

## Beschreibung

Die Erfindung betrifft eine Platinen-Steckkontakt-Anordnung mit einer mindestens einen Kontaktpin aufweisenden Steckkontakt-Einheit und mit einer mit der Steckkontakt-Einheit in elektrischen Kontakt bringbaren Platine.

Bei der Verbindung von Leiterbahnen oder Platinen mit externen Schaltungskreisen, wie einem Hauptschaltungskreis, Kabelbäumen, anderen Platinen u. dgl., werden die Signalzugänge bzw. -abgänge an den Platinen über eine Platinen-Steckkontakt-Anordnung mit den Signalab- bzw. -zugängen des externen Schaltungskreises oder den Leitungen dorthin verbunden. Viele dieser Platinen-Steckkontakt-Anordnungen werden üblicherweise realisiert, indem die bekannten, zweiteiligen, eine Steckbuchsenleiste und eine Steckerstiftleiste umfassenden Steckkontakt-Einheiten einerseits auf der Platine, andererseits an den externen Schaltungskreis oder den Leitungen dorthin aufgelötet oder vernietet werden.

Aus der DE 19 609 425-A1 ist eine Platinen-Steckkontakt-Anordnung bekannt, bei der ein gewinkelter Kontaktpin in ein Loch in der Platine unter Herstellung eines elektrischen Kontakts mit dem auf der Platine angeordneten Leiterbahnnetz eingepreßt wird. Zwischen der Lochwand und dem Kontaktpin befindet sich eine Kontakthülse, die den elektrischen Kontakt zwischen dem Kontaktpin und dem Leiterbahnnetz sicherstellen soll. Der gewinkelte Kontaktpin umfaßt zwei Schenkel, wobei der erste senkrecht zur Platine, wie oben beschrieben, teilweise in diese versenkt sowie eingepreßt wird und der zweite Schenkel den ersten in einem rechten Winkel in Steckrichtung über den Rand der Platine hinaus fortsetzt. Beim Verbinden dieser Platine mit einem externen Schaltungskreis wird der Kontaktpin-Fortsatz schließlich in eine für diesen passende Kontaktpinaufnahme, nämlich eine Steckkontakt-Buchse des externen Schaltungskreises, unter Herstellung eines elektrischen Kontakts mit den an den Kontaktpinempfänger anschließenden entsprechenden Leitungen eingeführt.

Bei diesen bekannten Ausführungsformen ist es von Nachteil, daß zur Herstellung der elektrischen Verbindung zwischen der Platine und dem externen Schaltungskreis ein enormer Platzbedarf für das Anbringen von Steckern oder Pins auf der Platine notwendig ist. Dadurch kann es zu lay-out-technischen Nachteilen hinsichtlich der Platinenarchitektur kommen, was unter Umständen sehr geringe Leiterbahnbreiten und einen Wegfall von Prüfpunkten auf der Platine nach sich ziehen kann. Dies führt zu einer hohen Ausfallwahrscheinlichkeit des Platinen-Schaltungskreises.

Ferner bestehen bei den bekannten Platinen-Steckkontakt-Anordnungen fertigungstechnische Nachteile, da das Anordnen des Steckers und der Kontaktpins auf der Platine meist durch Handbestückung durchgeführt wird, was häufig zu Verwechslungen der Bauelemente führen kann.

Auch sind die bekannten Platinen-Steckkontakt-Anordnungen dann anfällig, wenn die mit den Platinen versehene Schaltung starken Vibrationen ausgesetzt ist. In den meist starren Verbindungen von Platinen-Steckkontakt-Anordnungen treten häufig durch Ermüdungsverschleiß bedingte Risse und Brüche auf, die zu Signalübertragungsfehler führen können.

Zusätzlich ist es bei Platinen mit aufgelöteten oder vernieteten Steckerteilen von Nachteil, daß bei manchen dieser Anordnungen ein wasserdichtes Verschließen einer Platine fertigungstechnisch nur noch mit sehr großem Aufwand realisierbar ist.

Aus der EP 0 546 804 A2 ist eine elektrische Kopplungsanordnung für eine Platine mit streifenartigen Kontaktzonen an ihrer Koppelseite bekannt. Die mit den Kontaktstreifen versehene Koppelseite der Platine wird in einen Stecker eingesetzt und unter Zuhilfenahme einer an dem Stecker angeordneten Verrasteinrichtung fixiert, wobei der Stecker zu den Kontaktstreifen der Platine entsprechende Kontaktanschlüsse aufweist. Bei dieser Anordnung ist es von Nachteil, daß zur Fixierung der Platine eine zusätzliche Einrichtung für eine mechanische Arretierung der Platine in Form einer Verrasteinrichtung notwendig ist. Außerdem erfordert die Benutzung von Kontaktflächen eine außerordentlich genaue Herstellung letzterer, um einen sicheren elektrischen Kontakt zwischen Platine und Anschlußelement zu gewährleisten.

Die US-A-3,594,699 zeigt eine Platinen-Steckkontakt-Anordnung, bei der die Funktionen der mechanischen Halterung und der elektrischen Kontaktierung von verschiedenen Bauteilen wahrgenommen werden. So sind an der Steckkontakt-Anordnung aus Isolierstoff bestehende Vorsprünge vorgesehen, die in eine entsprechende Ausnehmung in der Platine einschnappen. Die elektrische Kontaktierung wird durch gebogene Kontaktfedern hergestellt, die an der Außenseite der Platine auf entsprechenden Leiterbahnflächen aufliegen. Die mechanische Verbindung zwischen Platine und Steckontakt ist bezüglich Einstecken und Trennen nicht spezifisch ausgebildet.

Die US-A-3,858,957 zeigt eine Platinen-Steckkontakt-Anordnung, bei der die Kontaktfedern Ausbauchungen zur mechanischen Halterung aufweisen. Da mit der dort gezeigten Kontaktanordnung ein leichtgängiges Herstellen und Lösen der Kontaktverbindung erreicht werden sollen, sind keine Maßnahmen für eine dauerhafte Arretierung der Kontaktpartner vorgesehen.

Ausgehend von dem vorgenannten Stand der Technik ist es eine Aufgabe der vorliegenden Erfindung, eine leicht zu fertigende Platinen-Steckkontakt-Anordnung zu schaffen, die ihren Platzbedarf auf der Platine für das Herstellen des elektrischen Kontaktes und der mechanischen Arretierung mit einem externen Schaltungskreis auf ein Minimum reduziert und dabei eine sichere, quasi unlösbare Befestigung gewährleistet.

Diese Aufgabe wird dadurch gelöst, daß der mindestens eine Kontaktpin einen quer zur Kontaktpinachse abstehenden Einrastvorsprung und die Platine mindestens eine Ausnehmung aufweist, in die jeweils ein Einrastvorsprung unter Herstellung eines elektrischen Kontakts mit der Platine eingreift, wobei erfindungsgemäß der Einrastvorsprung eine jeweils in spitzem Winkel zur Kontaktpinachse liegende Aufschiebflanke und Rastflanke aufweist, wobei der spitze Winkel zwischen der Aufschiebflanke und der Kontaktpinachse kleiner als der spitze Winkel zwischen der Rastflanke und der Kontaktpinachse ist, um eine mechanische Arretierung mit der Platine und zugleich ein einfaches Aufschieben der Platine zu gewährleisten.

Hierbei ist es von Vorteil, daß durch die unsymmetrische Nasenform des Einrastvorsprungs keine weitere Arretierungseinrichtung auf der Platine für das Anbringen dieser notwendig ist. Außerdem werden jegliche Lötvorgänge durch das mechanische Einrasten der Einrastvorsprünge der Kontaktpins in die dafür vorgesehenen Ausnehmungen in der Platine ersetzt.

Insbesondere muß bei der erfindungsgemäßen Platinen-Steckkontakt-Anordnung der Kontaktstecker nicht mehr auf der Platine angebracht werden. Aufgrund der parallelen sowie sehr nahen Anordnung der Kontaktpins an der Platine wird eine gute Filterung der Ein- und Ausgangssignale und somit eine geringe Koppelwirkung der Kontaktpins untereinander und zum inneren Bereich der Platine realisiert.

Um das Aufschieben der Platine für den Einrastvorgang besonders einfach durchführen zu können, weist der Einrastvorsprung eine jeweils im spitzen Winkel zur Kontaktpinachse liegende Aufschiebflanke und Rastflanke auf, wobei der spitze Winkel zwischen der Aufschiebflanke und der Kontaktpinachse kleiner als der spitze Winkel zwischen der Rastflanke und der Kontaktpinachse ist.

Eine besonders zuverlässige Kontaktierung des Kontaktpins mit der Platine wird sichergestellt, indem der Kontaktpin im Bereich des Einrastvorsprungs zur Ausnehmung in der Platine hin scharfkantig ausgebildet ist. Hierbei ist es günstig, die Innenfläche der Platinenbohrung mit einer Metallbeschichtung zu versehen.

Eine platzsparende Kontaktpinanordnung bei der erfindungsgemäßen Platinen-Steckkontakt-Anordnung wird geschaffen, indem mindestens zwei in Reihe angeordnete Platinenbohrungen an der Platine ausgebildet und entsprechend Kontaktpins derart angeordnet sind, daß die Einrastvorsprünge jeweils abwechselnd an der Platinenober- und -unterseite in die entsprechende Platinenanordnung einrasten. Eine solche Anordnung ist auch gerade bei solchen Systemen günstig, die Vibrationen ausgesetzt sind. Wenn mehrere Kontaktpins für eine Platine wechselweise von der Platinenober- und -unterseite aus verrasten, entsteht dabei auf Grund der Elastizität der dünnen Kontaktpins eine Vibrationen aufnehmende, elastische Aufnahme der Platine.

Eine weitere vorteilhafte Ausführungsform für eine erfindungsgemäße Platinen-Steckkontakt-Anordnung wird geschaffen, indem die Platine mehrere Ausnehmungen in Reihe aufweist und mehrere entsprechende Kontaktpins in einer Ebene, die vorzugsweise senkrecht zur Platine liegt, derart angeordnet sind, daß die Länge der Rastflanke bezogen auf jeweils eine Seite der Platine zur Platinenmitte hin zunimmt.

Außerdem können die einzelnen Kontaktpins einer Steckkontakt-Einheit verschiedene Platinen kontaktieren.

Um die Platine wasserdicht abzuschließen, ist ein Gehäuse mit einer Einschuböffnung für die Platine an der Steckkontakt-Einheit angeordnet, wobei die Platine in das Gehäuse entlang einer an dem Gehäuse angebrachten Führung eingeschoben wird.

Herstellungstechnisch ist es günstig, die Steckkontakt-Einheit einstückig mit dem Gehäuse auszubilden, wobei vorzugsweise die Steckkontakt-Einheit und das Gehäuse aus Kunststoff gegossen sind.

Eine vorteilhafte Ausführungsform wird realisiert, wenn der mindestens eine Kontaktpin in der Steckkontakt-Einheit eingebettet ist, so daß das eine seiner beiden freien Enden in einen von dem Gehäuse umgebenden inneren Steckerbereich und das andere freie Ende des Kontaktpins in einen äußeren Steckerbereich ragen. Die in das Gehäuse geschobene Platine ist am inneren Steckerbereich aufgrund des Verrastens des Einrastvorsprungs des mindestens einen Kontaktpins mit der jeweiligen Platinenausnehmung zumindest in Schieberichtung festlegbar. Insofern ist es möglich, den äußeren Steckerbereich auch am Ende eines Kabelbaums anzuordnen.

Bei einer Platinen-Steckkontakt-Anordnung mit einem Gehäuse können größere Bauelemente, die viel Platz auf der Platine beanspruchen, an dem Gehäuse angeordnet werden.

Weitere Vorteile und Merkmale der Erfindung ist der Beschreibung der beiliegenden Zeichnungen zu entnehmen, in denen zeigen:
- Fig. 1: einen Kontaktpin der erfindungsgemäßen Platinen-Steckkontakt-Anordnung;
- Fig. 2: eine erste Ausführungsform der erfindungsgemäßen Platinen-Steckkontakt-Anordnung;
- Fig. 3: eine zweite Ausführungsform der erfindungsgemäßen Platinen-Steckkontakt-Anordnung;
- Fig. 4: eine schematische perspektivische Ansicht eines Gehäuses für eine Platinen-Steckkontakt-Anordnung; und
- Fig. 5: eine schematische Querschnittsansicht einer erfindungsgemäßen Platinen-Steckkontakt-Anordnung mit einem Gehäuse.

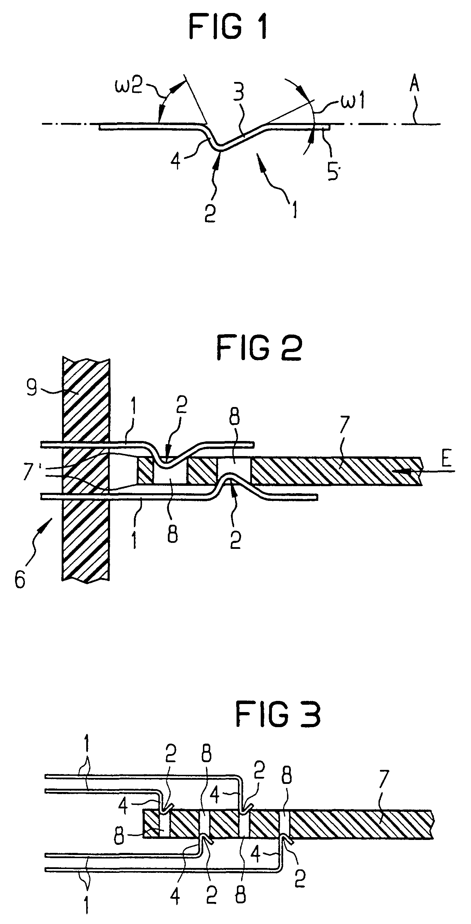

In Fig. 1 ist ein Kontaktpin 1 ersichtlich, der einen Einrastvorsprung 2 in Form einer unsymmetrischen Nase aufweist. Der Einrastvorsprung 2 umfaßt eine Aufschiebflanke 3 und eine Rastflanke 4. Beide Flanken 3, 4 besitzen einen spitzen Winkel zu der Kontaktpinachse A. Der spitze Winkel w1 zwischen der Aufschiebflanke 3 und der Kontaktpinachse A ist kleiner als der spitze Winkel w2 zwischen der Rastflanke 4 und der Kontaktpinachse. An die Aufschiebflanke 3 schließt ein Endstück 5 an, das in der Kontaktpinachse A liegt.

In Fig. 2 sind zwei Kontaktpins 1 mit zueinander parallelen Kontaktpinachsen A gezeigt, die in einer eine Kontaktpin-Halterung 9 umfassenden Steckkontakt-Einheit 6 eingebettet sind, wobei die Kontaktpin-Halterung 9 aus einem isolierenden Material gebildet ist. Die Einrastvorsprünge 2 der Kontaktpins 1 sind axial versetzt angeordnet, wobei jeweils Rastflanke 4 und Einschiebeflanke 3 von ihrer Kontaktpinachse A weg zum jeweils anderen Kontaktpin 1 gerichtet sind. Zwischen den beiden Kontaktpins 1 ist eine Platine 7 eingeschoben, die in demjenigen Platinen-Bereich, der der Steckkontakt-Einheit 6 am nächsten liegt, Bohrungen 8 aufweist.

Zum Einrasten der Einrastvorsprünge 2 des Kontaktpins 1 in die Bohrungen 8 wird die Platine 7 parallel zu den feststehenden Kontaktpins 1 derart in Einschieberichtung E bewegt, daß die Kontaktpins 1 aufgrund des Zusammenspiels zwischen Aufschiebeflanken 3 der Kontaktpins 1 und dem Randbereich 7' der Platine 7 sowie der Schiebebewegung der Platine 7 von dieser weg gebogen und somit elastisch vorgespannt werden. Die maximale Vorspannung wird erreicht bzw. aufrechterhalten, wenn die Nase des Einrastvorsprungs 2 auf der Platine 7 aufliegt bzw. auf dieser zur entsprechenden Bohrung 8 verschoben wird. In dem Augenblick, in dem die unsymmetrische Nase des Einrastvorsprungs 2 des Kontaktpins 1 mit der Bohrung 8 der Platine 7 fluchtet und in diese einschnappt, ist der elektrische Kontakt zwischen Kontaktpin und dem nicht dargestellten Leiterbahnnetz der Platine 7 hergestellt. Der guten Ordnung halber ist darauf hinzuweisen, daß der Einrastvorsprung 2 des unteren Kontaktpins 1 zuerst in die äußere Bohrung 8 rastet, diese wieder verläßt und dann in die innere Bohrung 8 endgültig einrastet.

In Fig. 3 sind vier Kontaktpins mit den in die entsprechenden Bohrungen 8 der Platine 7 eingeschnappten Einrastvorsprüngen 2 gezeigt. Die vier Kontaktpins 1 liegen in einer gemeinsamen Ebene, die senkrecht zu der der Platine 7 liegt und der Papierebene entspricht. Um eine gegenseitige Beeinflussung der Kontaktpins zu vermeiden, sind sie mit einem ausreichenden Abstand zueinander angeordnet, wobei die Länge der Rastflanke 4 der in einer Ebene liegenden Kontaktpins 1 bezogen auf jeweils eine Platinenseite zur Platinenmitte hin zunimmt.

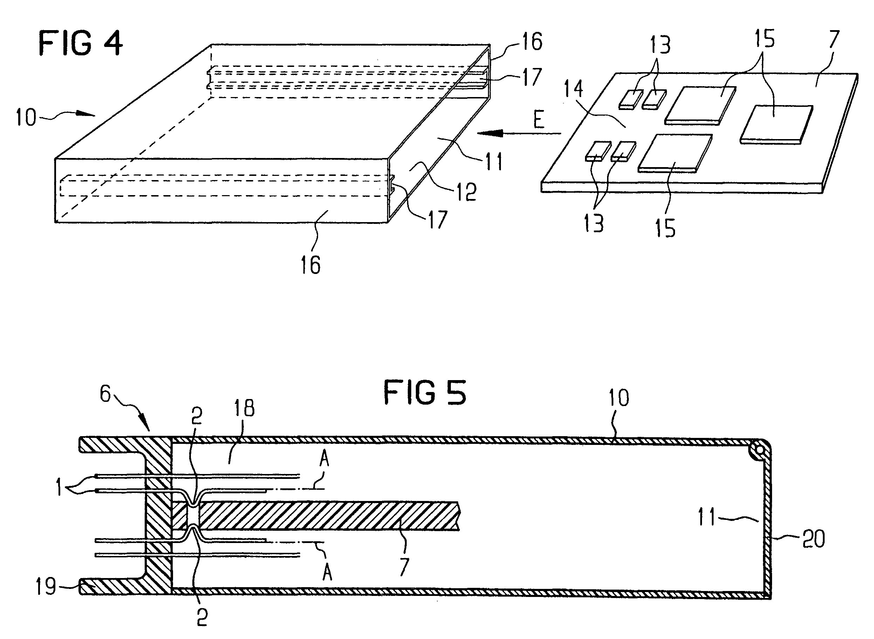

In Fig. 4 ist ein Gehäuse 10 der erfindungsgemäßen Platinen-Steckkontakt-Anordnung aufgezeigt. Dieses Gehäuse umfaßt eine Einschuböffnung 11 sowie einen Gehäuseboden 12, der die in Fig. 4 nicht dargestellte Steckkontakt-Einheit aufweist. Die Platine 7 mit auf dieser angeordneten Elektronik-Komponenten 15 wird in Einschieberichtung E in das Gehäuse 10 eingeführt, wobei die vorzugsweise als Bohrungen 8 ausgebildete Ausnehmungen 13 in der Platine an ihrem Randbereich 14 angeordnet sind, der sich im eingeschobenen Zustand in der Nähe des Gehäusebodens 12 befindet. Ein bequemes Einschieben sowie ein treffsicheres Einschnappen der Einrastvorsprünge 2 der Kontaktpins 1 in die Ausnehmungen 13 wird von den an den Gehäuseseiten 16 angeordneten Führungsnuten 17 sichergestellt.

In Fig. 5 ist eine Platine 7 im eingeschobenen Zustand dargestellt. In der Kontaktpin-Halterung 9 sind die Kontaktpins 1 eingebettet und an diese anschließend ist einstückig ein Gehäuse 10 angeordnet, das einen inneren 18 sowie äußeren Stekkerbereich 19 voneinander trennt. In den inneren Steckerbereich 18 ragen die Kontaktpins 1 mit ihren Einrastvorsprüngen 2, wobei in Fig.5 nur zwei Kontaktpins dargestellt sind, die zusammen mit den nicht dargestellten Führungsnuten 17 die Position der Platine 7 festlegen.

Um den inneren Steckerbereich 18 wasserdicht zu verschließen, wird die Einschuböffnung 11 mittels eines Deckels 20 gegebenenfalls mit Hilfe von Dichtungseinrichtungen verschlossen, insbesondere verklebt oder verschweißt.

In den äußeren Steckerbereich 19 ragen die freien Enden der Kontaktpins 1 ohne Einrastvorsprung 2, wobei der äußere Stekkerbereich 19 als das freie Ende eines Kabelbaums ausgebildet sein kann. Mit anderen Worten schließt in diesem Fall an das freie Ende des Kabelbaums das Gehäuse 10 an. Die in dem Gehäuseinneren aus dem freien Ende des Kabelbaums austretenden Kontaktgegenstücke sind als erfindungsgemäße Kontaktpins ausgebildet, die die Aufnahme der in das Gehäuse eingeschobenen Platinen 7 realisiert.

Das in den Figuren 4 und 5 dargestellte Gehäuse 10 kann auch so dimensioniert sein, daß mehrere Platinen 7 in das Gehäuse 10 eingeschoben und von entsprechenden Kontaktpins 1 unter Herstellung eines elektrischen Kontakts verrastbar sind.

## Patentansprüche

1. Platinen-Steckkontakt-Anordnung mit
- einer mindestens einen elastischen Kontaktpin (1) aufweisenden Steckkontakt-Einheit (6) und
- einer mit der Steckkontakt-Einheit (6) in elektrischen Kontakt bringbaren Platine (7),
wobei der mindestens eine Kontaktpin (1) einen quer zur Kontaktpinachse (A) abstehenden Einrastvorsprung (2) und die Platine (7) mindestens eine Ausnehmung (13) aufweist, in die jeweils ein Einrastvorsprung (2) unter Herstellung eines elektrischen Kontakts mit der Platine (7) eingreift,
**dadurch gekennzeichnet, daß** der Einrastvorsprung (2) eine jeweils in spitzem Winkel (w1, w2) zur Kontaktpinachse liegende Aufschiebflanke (3) und Rastflanke (4) aufweist, wobei der spitze Winkel (w1) zwischen der Aufschiebflanke (3) und der Kontaktpinachse (A) kleiner als der spitze Winkel (w2) zwischen der Rastflanke (4) und der Kontaktpinachse ist, um eine mechanische Arretierung mit der Platine (7) und zugleich ein einfaches Aufschieben der Platine (7) zu gewährleisten.

2. Platinen-Steckkontakt-Anordnung nach Anspruch 1,
**dadurch gekennzeichnet, daß** der mindestens eine Kontaktpin (1) ein sich an der Aufschiebflanke (3) anschließendes Endstück (5) aufweist, das in der Kontaktpinachse (A) liegt.

3. Platinen-Steckkontakt-Anordnung nach einem der Ansprüche 1 oder 2, **dadurch gekennzeichnet, daß** der mindestens eine Kontaktpin (1) im Bereich des Einrastvorsprungs (2) zur Ausnehmung (13) in der Platine (7) hin scharfkantig ausgebildet ist.

4. Platinen-Steckkontakt-Anordnung nach einem der Ansprüche 1 bis 3, **dadurch gekennzeichnet, daß** die mindestens eine Ausnehmung (13) in der Platine (7) als Bohrung (8) ausgebildet ist.

5. Platinen-Steckkontakt-Anordnung nach Anspruch 4, **dadurch gekennzeichnet, daß** die Innenfläche der Bohrung (8) mit einer Metallbeschichtung versehen ist.

6. Platinen-Steckkontakt-Anordnung nach einem der Ansprüche 4 oder 5, **dadurch gekennzeichnet, daß** mindestens zwei in Reihe angeordnete Bohrungen (8) an der Platine (7) ausgebildet und entsprechend Kontaktpins (1) derart angeordnet sind, daß die Einrastvorsprünge (2) jeweils abwechselnd an der Platinenoberseite und Platinenunterseite in die entsprechende Bohrung (8) einrasten.

7. Platinen-Steckkontakt-Anordnung nach einem der Ansprüche 1 bis 6, **dadurch gekennzeichnet, daß** die Platine (7) mehrere Ausnehmungen (13) in Reihe aufweist und entsprechend mehrere Kontaktpins (1) in einer Ebene, die vorzugsweise senkrecht zur Platine (7) liegt, derart angeordnet sind, daß die Länge der Rastflanke (4) bezogen auf jeweils eine Seite der Platine (7) zur Platinenmitte hin zunimmt.

8. Platinen-Steckkontakt-Anordnung nach einem der Ansprüche 1 bis 7, **dadurch gekennzeichnet, daß** die einzelnen Kontaktpins (1) einer Steckkontakt-Einheit (6) verschiedene Platinen (7) kontaktieren.

9. Platinen-Steckkontakt-Anordnung nach einem der Ansprüche 1 bis 8, **dadurch gekennzeichnet, daß** ein Gehäuse (10) an der Steckkontakt-Einheit (6) angeordnet ist, wobei die Platine (7) in das Gehäuse (10) entlang einer an das Gehäuse angebrachten Führung (17) einschiebbar ist.

10. Platinen-Steckkontakt-Anordnung nach einem der Ansprüche 1 bis 9, **dadurch gekennzeichnet, daß** die Steckkontakt-Einheit (6) einstückig mit dem Gehäuse (10). ausgebildet ist, das eine Einschuböffnung (11) für die Platine (7) aufweist, wobei vorzugsweise die Steckkontakt-Einheit (6) und das Gehäuse (10) aus Kunststoff gegossen sind.

11. Platinen-Steckkontakt-Anordnung nach einem der Ansprüche 9 oder 10, **dadurch gekennzeichnet, daß** der mindestens eine Kontaktpin (1) in der Steckkontakt-Einheit (6) derart angeordnet, vorzugsweise eingebettet, ist, daß das eine seiner beiden freien Enden in einen von dem Gehäuse (10) umgebenden inneren Steckerbereich (18) und das andere in einen äußeren Steckerbereich (19) ragen, wobei die in das Gehäuse (10) geschobene Platine (7) am inneren Steckerbereich (18) aufgrund des Verrastens des Einrastvorsprungs (2) des mindestens einen Kontaktpins in Einschieberichtung (E) festlegbar ist.

12. Platinen-Steckkontakt-Anordnung nach einem der Ansprüche 10 oder 11, **dadurch gekennzeichnet, daß** die Einschuböffnung (11) des Gehäuses (10) von einem Deckel (20) wasserdicht verschlossen ist.

13. Platinen-Steckkontakt-Anordnung nach einem der Ansprüche 11 oder 12, **dadurch gekennzeichnet, daß** der äußere Steckerbereich (19) am Ende eines Kabelbaums angeordnet ist.

14. Platinen-Steckkontakt-Anordnung nach einem der Ansprüche 9 bis 13, **dadurch gekennzeichnet, daß** mehrere Platinen (7) in das Gehäuse (10) mittels entsprechender Führungen (17) einschiebbar und unter Herstellung eines elektrischen Kontakts mit den entsprechenden Kontaktpins (1) verrastbar sind.

## Claims

1. Board plug-in contact arrangement with
- a plug-in contact unit (6) which has at least one resilient contact pin (1) and
- a board (7) which can be brought into electrical contact with the plug-in contact unit (6),
whereby at least one contact pin (1) has a latching projection (2) projecting transverse to the contact pin axis (A) and the board (7) has at least one recess (13) in which a latching projection (2) engages in each case to make electrical contact with the board (7),
**characterised in that** the latching projection (2) has a sliding face (3) and latching face (4) each at an acute angle (w1, w2) to the contact pin axis, whereby the acute angle (w1) between the sliding face (3) and the contact pin axis (A) is smaller than the acute angle (w2) between the latching face (4) and the contact pin axis, to guarantee a mechanical locking with the board (7) and at the same time guarantee that the board (7) can be easily slid in.

2. Board plug-in contact arrangement according to Claim 1, **characterised in that** at least one contact pin (1) has an end piece (5) as a termination of the sliding face (3), which lies in the contact pin axis (A).

3. Board plug-in contact arrangement according to one of Claims 1 or 2, **characterised in that** at least one of the contact pins (1) is formed with sharp edges in the area of the latching projection (2) towards the recess (13) in the board (7).

4. Board plug-in contact arrangement according to one of Claims 1 to 3, **characterised in that** at least one recess (13) in the board (7) is formed as a hole (8).

5. Board plug-in contact arrangement according to Claim 4, **characterised in that** the inner face of the hole (8) is provided with a metal coating.

6. Board plug-in contact arrangement according to one of Claims 4 or 5, **characterised in that** at least two of the holes (8) arranged in line on the board (7) are formed, and corresponding contact pins 1 are arranged, such that the latching projections (2) in each case engage alternately, on the top of the board and bottom of the board, in the corresponding hole (8).

7. Board plug-in contact arrangement according to one of Claims 1 to 6, **characterised in that** the board (7) has several recesses (13) in line and several corresponding contact pins (1) in a plane, which advantageously lies perpendicular to the board (7), and are arranged such that the length of the latching face (4) increases towards the centre of the board relative to one side of the board (7) in each case.

8. Board plug-in contact arrangement according to one of Claims 1 to 7, **characterised in that** the individual contact pins (1) of a plug-in contact unit (6) contact different boards (7).

9. Board plug-in contact arrangement according to one of Claims 1 to 8, **characterised in that** a housing (10) is arranged at the plug-in contact unit (6), whereby the board (7) can be slid into the housing (10) along a guide (17) fitted to the housing.

10. Board plug-in contact arrangement according to one of Claims 1 to 9, **characterised in that** the plug-in contact unit (6) is designed to form a single piece with the housing (10), which has a slide-in opening (11) for the board (7), whereby the plug-in contact unit (6) and the housing (10) are advantageously cast from plastic.

11. Board plug-in contact arrangement according to one of Claims 9 or 10, **characterised in that** at least one contact pin (1) is arranged in the plug-in contact unit (6) in such a way, preferably embedded, that one of the two free ends projects into an inner connector area (18) surrounded by the housing (10) and the other end projects into an outer connector area (19), whereby the board (7) slid into the housing (10) can be located in the inner connector area (18) in a slide-in direction (E) because of the latching of the latching projection (2) of at least one contact pin.

12. Board plug-in contact arrangement according to one of Claims 10 or 11, **characterised in that** the slide-in opening (11) of the housing (10) is sealed watertight by a cover (20).

13. Board plug-in contact arrangement according to one of Claims 11 or 12, **characterised in that** the outer connector area (19) is arranged on the end of a cable harness.

14. Board plug-in contact arrangement according to one of Claims 9 to 13, **characterised in that** several boards (7) can be slid into the housing (10) by means of suitable guides (17) and can be latched to form an electrical contact with the corresponding contact pins (1).

## Revendications

1. Ensemble circuit imprimé-contact embrochable comprenant
- une unité de contact embrochable (6) présentant au moins une broche de contact élastique (1) et
- un circuit imprimé (7) qui peut être mis en contact électrique avec l'unité de contact embrochable (6),
dans lequel l'au moins une broche de contact (1) présente une saillie d'enclenchement (2) qui fait saillie transversalement à l'axe (A) de la broche de contact et le circuit imprimé (7) présente au moins un évidement (13) dans lequel une saillie d'enclenchement (2) s'engage en établissant un contact électrique avec le circuit imprimé (7),
**caractérisé en ce que** la saillie d'enclenchement (2) présente un flanc d'emmanchement (3) et un flanc d'enclenchement (4) qui forment chacun un angle aigu (w1, w2) avec l'axe de la broche de contact, l'angle aigu (w2) entre le flanc d'emmanchement (3) et l'axe (A) de la broche de contact étant plus petit que l'angle aigu (w2) entre le flanc d'enclenchement (4) et l'axe de la broche de contact, afin de garantir un blocage mécanique avec le circuit imprimé (7) et, en même temps, la simplicité de l'emmanchement du circuit imprimé (7).

2. Ensemble circuit imprimé-contact embrochable selon la revendication 1,
**caractérisé en ce que** l'au moins une broche de contact (1) présente un embout (5) qui fait suite au flanc d'emmanchement (3) et qui se trouve dans l'axe (A) de la broche de contact.

3. Ensemble circuit imprimé-contact embrochable selon une des revendications 1 ou 2,
**caractérisé en ce que** l'au moins une broche de contact (1) est réalisée, dans la région de la saillie d'enclenchement (2) en formant une arête vive vers l'évidement (13) ménagé dans le circuit imprimé (7).

4. Ensemble circuit imprimé-contact embrochable selon l'une des revendications 1 ou 3,
**caractérisé en ce que** l'au moins un évidement (13) ménagé dans le circuit imprimé (7) est constitué par un perçage (8).

5. Ensemble circuit imprimé-contact embrochable selon la revendication 4,
**caractérisé en ce que** la surface intérieure du perçage (8) est munie d'un revêtement métallique.

6. Ensemble circuit imprimé-contact embrochable selon l'une des revendications 4 ou 5, **caractérisé en ce qu'**au moins deux perçages (8) disposés en une rangée sont formés dans le circuit imprimé (7) et des broches de contact (1) sont disposées de façon correspondante de manière que les saillies d'enclenchement (2) s'enclenchent respectivement en alternance sur la face supérieure du circuit imprimé et sur la face inférieure du circuit imprimé, dans le perçage (8) correspondant.

7. Ensemble circuit imprimé-contact embrochable selon l'une des revendications 1 à 6, **caractérisé en ce que** le circuit imprimé (7) présente plusieurs évidements (13) en une rangée et, de façon correspondante, plusieurs broches de contact (1) sont disposées dans un plan qui se trouve de préférence perpendiculairement au circuit imprimé (7), de telle manière que la longueur du flanc d'enclenchement (4) mesurée par rapport à une face du circuit imprimé (7), croisse en direction du centre du circuit imprimé.

8. Ensemble circuit imprimé-contact embrochable selon l'une des revendications 1 à 7, **caractérisé en ce que** les différentes broches de contact (1) d'une unité de contact embrochable (6) sont en contact avec différents circuits imprimés.

9. Ensemble circuit imprimé-contact embrochable selon l'une des revendications 1 à 8, **caractérisé en ce qu'**un boîtier (10) est disposé sur l'unité de contact embrochable (6), le circuit imprimé (7) pouvant être emmanché dans le boîtier (10) le long d'un guide (17) solidaire du boîtier.

10. Ensemble circuit imprimé-contact embrochable selon l'une des revendications 1 à 9, **caractérisé en ce que** l'unité de contact embrochable (6) est réalisée en une seule pièce avec le boîtier (10), lequel présente une ouverture d'emmanchement (11) pour le circuit imprimé (7), l'unité de contact embrochable (6) et le boîtier (10) étant de préférence moulés en matière plastique.

11. Ensemble circuit imprimé-contact embrochable selon l'une des revendications 1 ou 10, **caractérisé en ce que** l'au moins une broche de contact (1) est disposée, de préférence noyée, dans l'unité de contact embrochable (6) de telle manière que l'une des ses extrémités libres fasse saillie dans une zone intérieure (18) du contacteur qui est entourée par le boîtier (10) et l'autre dans une région extérieure (19) du contacteur, le circuit imprimé (7) emmanché dans le boîtier (10) pouvant être bloqué sur la zone intérieure (18) du connecteur grâce à l'enclenchement de la saillie d'enclenchement (2) de l'au moins une broche de contact dans la direction de l'emmanchement (E).

12. Ensemble circuit imprimé-contact embrochable selon l'une des revendications 10 ou 11, **caractérisé en ce que** l'ouverture d'emmanchement (11) du boîtier (10) est obturée à joint étanche à l'eau par un couvercle (20).

13. Ensemble circuit imprimé-contact embrochable selon l'une des revendications 11 ou 12, **caractérisé en ce que** la zone extérieure (19) du connecteur est disposée à l'extrémité d'un faisceau de câbles.

14. Ensemble circuit imprimé-contact embrochable selon l'une des revendications 9 à 13, **caractérisé en ce que** plusieurs circuits imprimés (7) peuvent être emmanchés dans le boîtier (10) au moyen de guides correspondants (17) et peuvent être enclenchés avec établissement d'un contact électrique avec les broches de contact (1) correspondantes.
